# EUROPÄISCHE PATENTSCHRIFT

(11) **EP 0 692 805 B1**
(45) Veröffentlichungstag und Bekanntmachung des Hinweises auf die Patenterteilung: **03.06.1998**
(21) Anmeldenummer: 95110015.5
(22) Anmeldetag: 23.06.1995
(51) Int. Cl.: H01H 50/14, H01H 1/58, H05K 3/34

(54) **Elektrisches Relais**
Electric relay
Relais électrique

(30) Priorität: 15.07.1994 DE 4425077
(43) Veröffentlichungstag der Anmeldung: 17.01.1996
(73) Patentinhaber: SIEMENS AKTIENGESELLSCHAFT, 80333 München (DE)
(72) Erfinder: Weiser, Josef, Dr., D-82069 Hohenschäftlarn (DE)

(56) Entgegenhaltungen:
- DE-A- 3 430 589
- GB-A- 2 050 906
- PATENT ABSTRACTS OF JAPAN vol. 015 no. 334 (E-1104) ,26.August 1991 & JP-A-03 127424 (FUJITSU LTD) 30.Mai 1991,
- PATENT ABSTRACTS OF JAPAN vol. 017 no. 653 (E-1469) ,3.Dezember 1993 & JP-A-05 217479 (FUJITSU LTD) 27.August 1993,
- PATENT ABSTRACTS OF JAPAN vol. 018 no. 455 (E-1595) ,24.August 1994 & JP-A-06 150798 (NEC CORP) 31.Mai 1994,

## Beschreibung

Die Erfindung betrifft ein elektrisches Relais mit einem Gehäuse, welches
- eine Bodenseite zum Aufsetzen auf eine Leiterplatte,
- aus der von der Bodenseite abgewandten Oberseite des Gehäuses austretende Anschlußelemente und
- mit den Anschlußelementen verbundene Anschlußbahnen aufweist, welche sich mit abgebogenen Abschnitten entlang von Seitenwänden des Gehäuses bis in den Bereich der Bodenseite erstrecken, wo sie mit Anschlußfahnen zur Kontaktierung auf der Leiterplatte versehen sind.

Bei herkömmlichen Relais treten die Anschlußleiter gewöhnlich aus der Bodenseite des Gehäuses aus, und die von ihnen gebildeten Anschlußfahnen werden in Bohrungen der Leiterplatte von der Leiterplattenunterseite her verlötet. In jüngerer Zeit kommt immer mehr, insbesondere für kleine Bauelemente, die sogenannte Oberflächenmontagetechnik (SMT) zum Einsatz, wobei die Bauelemente mit flachen Anschlußfahnen auf der Leiterplatte aufliegen und durch Wärmeeintrag von der Oberseite her verlötet werden. Dabei entsteht für die Bauteile eine einmalige, zwar kurzzeitige, aber dennoch hohe Wärmebelastung. Um Relais zusammen mit anderen Bauelementen in einem einheitlichen Arbeitsgang montieren und verlöten zu können, werden auch bei diesen Relais die an der Bodenseite oder aus den Seitenwänden im bodennahen Bereich austretenden Anschlußleiter zur Bildung von Flachkontakten parallel zur Bodenseite abgebogen (EP 0 171 808 B1). Das bedeutet für die Relais, daß Werkstoffe und Technologien höchsten Ansprüchen genügen müssen, was sich in hohen Herstellungskosten auswirkt. Unter anderem besteht dabei die Gefahr, daß durch Differenzen in den Wärmedehnungen der Materialien eine Dejustage im Inneren auftritt; dies ist vor allem durch die Nähe der Lötstellen zu den Gehäusedurchführungen im unteren Gehäusebereich bedingt. Durch das bei Relais zwangsläufig vorhandene freie Innenvolumen bewirkt die starke Erwärmung auch eine starke Druckerhöhung der Luft im Gehäuseinneren, was zu Undichtigkeiten führen kann.

Zur Vermeidung der beim Löten auftretenden Nachteile wurde auch bereits vorgeschlagen, die Anschlußleiter von Relais als Einpreßstiele auszubilden, so daß das Relais erst nach dem Löten auf der Leiterplatte aufgesetzt und durch Einpreßtechnik kontaktiert werden kann (DE 34 30 589 C2). Da nach den bisherigen Vorschlägen jedoch die Einpreßstiele und deren Einpreßschultern mehr oder weniger unmittelbar dort an den Anschlußleitern angeformt sind, wo diese aus dem unteren Bereich des Relaisgehäuses austreten, besteht die Gefahr, daß die Einpreßkräfte unmittelbar auf den abgedichteten Durchführungsbereich und in das Relaisinnere übertragen werden, wo sie sich negativ auf die Abdichtung und auf die Justierwerte des Relais auswirken können.

Aus JP-A-3127424 ist ein Relais der eingangs genannten Art bekannt, bei dem eine flexible, Anschlußbahnen enthaltende Leiterplatte mit ihren Einstecköffnungen auf aus der Oberseite des Gehäuses austretende Anschlußstifte aufgesteckt und dort angelötet ist. Aufgrund der geringen mechanischen Festigkeit der Leiterplatte ist keine Ausbildung der Anschlußfahnen im Bereich der Bodenseite des Relais zu Einpreßstiften möglich. Der geringe Abstand zwischen den Lötstellen und den Gehäusedurchführungen stellt einen weiteren Nachteil bei dem in JP-A-3127424 beschriebenen Relais dar.

Ziel der vorliegenden Erfindung ist es, ein Relais der eingangs genannten Art konstruktiv so zu gestalten, daß sich Wärme und mechanische Einpreßkräfte im Bereich der Anschlußfahnen nicht auf die Abdichtung und auf die Justierung im Relaisinneren auswirken können.

Erfindungsgemäß wird dieses Ziel dadurch erreicht, daß die Anschlußelemente und die zugehörigen Anschlußbahnen durch jeweils einen gemeinsamen, formstabilen Anschlußleiter gebildet sind.

Der wesentliche Gedanke der Erfindung besteht darin, das Relais gegenüber herkömmlichen Bauformen umzudrehen, so daß die Anschlußleiter nicht unmittelbar aus der Bodenseite oder aus dem bodennahen Bereich, sondern aus der von der Leiterplatte abgewandten Relaisoberseite austreten und dann durch entsprechende Formgebung an den Gehäuseseiten nach unten geführt sind, wo sie die entsprechenden Anschlußfahnen bilden, vorzugsweise als Einpreßstiele ausgebildet sind. Die Anschlußleiter besitzen dadurch eine große Länge, so daß die beim Einpressen auftretenden Kräfte nicht oder nur in geringem Maße auf die an der Oberseite des Gehäuses liegenden Abdichtzonen übertragen werden, dort also keine Schäden für die Dichtigkeit erzeugen können. Zusätzlich sind Spannungen durch unterschiedliche Wärmedehnungen des Relais und der Leiterplatte von den Einpreßzonen entkoppelt. Die Einpreßverbindung ist also dadurch nicht gefährdet. Bei Ausbildung der Anschlußfahnen als Einpreßstiele entfallen die hohen Temperaturbelastungen des Relais gänzlich, was unter Umständen die Verwendung preisgünstiger Werkstoffe ermöglicht. Ein weiterer Vorteil der an der Oberseite austretenden Anschlußleiter besteht darin, daß sie für Prüfungen am eingebauten Relais gut zugänglich sind.

Obwohl die Erfindung vornehmlich für eine Anwendung der Einpreßtechnik, also für eine Gestaltung der Anschlußfahnen als Einpreßstiele, konzipiert ist, kommt ein Teil der Vorteile auch dann zur Geltung, wenn die Anschlußfahnen für die Oberflächenmontage (SMT) gestaltet sind. Bei dem für die SMT-Lötung erforderlichen Wärmeeintrag von oben wird diese Wärme nämlich durch die an den Flanken des Relais herablaufenden Anschlußleiter besonders schnell zu den Lötstellen transportiert, so daß nur eine kurzzeitige Wärmeeinwirkung erforderlich ist. Auch in diesem Fall sind überdies die Dichtstellen weit von den Lötstellen entfernt und von diesen entkoppelt, so daß auch hierbei die Gefahr einer Dejustierung vermindert ist.

Besonders günstig wirkt sich in diesem Fall der SMT-Lötung auf die Tatsache aus, daß die Austrittsseite der Anschlußleiter, die durch einen Sockel und durch eine abdichtende Vergußmasse gebildet ist, die bei herkömmlichen Relais die Bodenseite bildet, nunmehr bei dem erfindungsgemäß gestalteten Relais die Oberseite darstellt und der Löt-Wärmestrahlung zugewandt ist. Denn während die Gehäusekappe in der Regel aus einem Thermoplast hergestellt ist, besteht der Sockel aus einem formstabilen Werkstoff, und als Vergußmasse dient in der Regel Epoxitharz, das als duroplastisches Material thermisch wesentlich stabiler ist. Durch die erfindungsgemäße Umkehrung von Oberseite und Bodenseite gegenüber herkömmlichen Relais wird also die gegenüber Wärmeeinstrahlung unempfindlichere Relaisseite der Lötwärme zugewandt.

Falls durch die an der Gehäuseaußenseite verlaufenden Anschlußleiter des Relais Isolationsprobleme gegenüber benachbarten Bauelementen auftreten, so können diese durch zusätzliche Folien, insbesondere aber durch eine nachträglich aufsteckbare Überkappe aus Isolierstoff behoben werden.

Die Erfindung wird nachfolgend an Ausführungsbeispielen anhand der Zeichnung näher erläutert. Es zeigen
Figuren 1 bis 3 ein erfindungsgemäß gestaltetes Relais mit Einpreßstielen in drei verschiedenen Ansichten,
Figur 4 eine Montageanordnung für ein Relais mit Einpreßstiften,
Figur 5 eine Anordnung von Relais mit Kontakten zur Oberflächenmontage (SMT),
Figur 6 ein Relais mit isolierender Überkappe und
Figuren 7 bis 9 ein Relais in drei Ansichten entsprechend den Figuren 1 bis 3, jedoch mit abgewandelter Kappe.

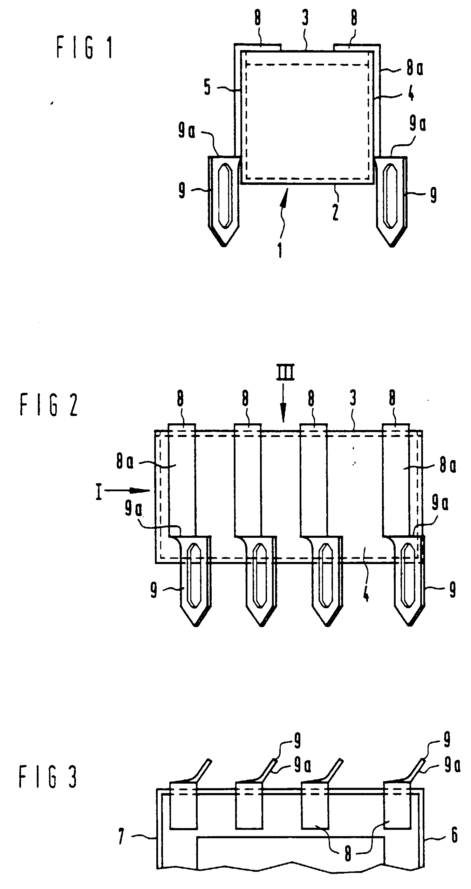

Das in den Figuren 1 bis 3 gezeigte Relais besitzt ein Gehäuse 1, das in seinem Inneren ein nicht sichtbares, beliebig gestaltetes Relaissystem enthält. Das Gehäuse besitzt eine geschlossene Bodenseite 2 zum Aufsetzen auf eine Leiterplatte, eine der Bodenseite gegenüberliegende Oberseite 3 sowie Längsseitenwände 4 und 5 und Querseitenwände 6 und 7. Aus der Oberseite 3 treten Anschlußleiter 8 für die Kontakte und die Spulenwicklung des Relais aus, wobei die Durchführungen der Anschlußleiter und gegebenenfalls sonstige Gehäusespalte in der Oberseite 3 abgedichtet sind, wie dies bei herkömmlichen Relais meist in der Bodenseite geschieht. Die aus Blechstreifen gebildeten Anschlußleiter 8 sind über die oberseitigen Gehäusekanten gebogen und laufen mit ihren Mittelabschnitten 8a entlang des Längsseiten 4 und 5 des Relais nach unten, wo sie in der Nähe der Bodenseite zur Bildung von Einpreßstielen 9 mit an der Oberseite geformten Einpreßschultern 9a abgekröpft sind.

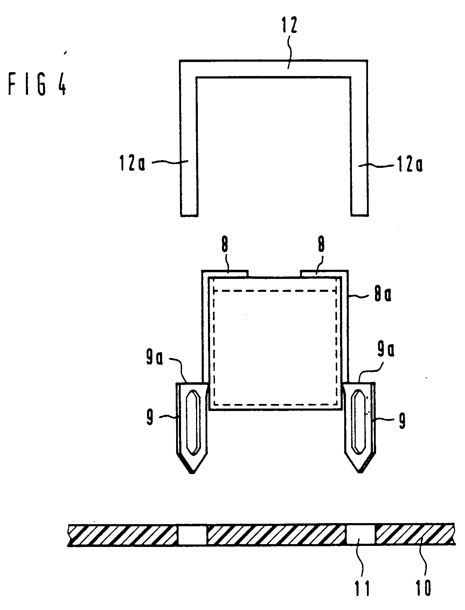

Die Montage des Relais gemäß den Figuren 1 bis 3 ist in Figur 4 gezeigt. Eine Leiterplatte 10 besitzt Kontaktbohrungen 11, die in bekannter Weise mit leitendem Material kaschiert sind. Ein Relais mit dem Gehäuse 1 und den Einpreßstielen 9 wird auf die Leiterplatte 10 aufgesetzt, so daß die Einpreßstiele 9 mit den Kontaktbohrungen 11 fluchten. Mit einem U-förmig gestalteten Einpreßwerkzeug 12, dessen Schenkel 12a auf die Einpreßschultern 9a drücken, werden die Einpreßstiele 9 mit der erforderlichen Einpreßkraft in die Bohrungen 11 gepreßt und so kontaktiert. Die Seitenschenkel 12a des Einpreßwerkzeuges 12 sind dabei so an die Außenkonturen des Gehäuses 1 und der Mittelabschnitte 8a der Anschlußleiter angepaßt, daß letztere beim Einpressen gehalten und gegen Verbiegen geschützt werden.

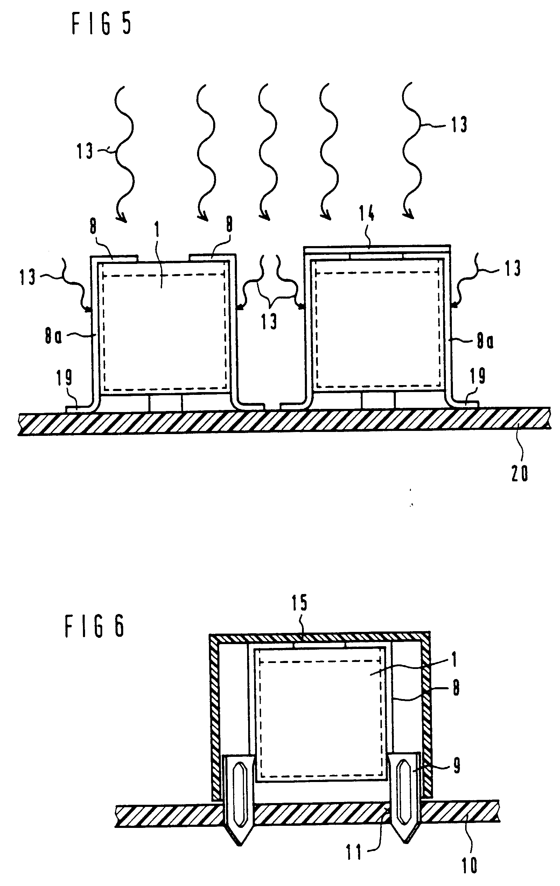

Figur 5 zeigt eine andere Ausgestaltung eines erfindungsgemäßen Relais, und zwar für die Oberflächenmontagetechnik (SMT). Wie in den vorhergehenden Beispielen treten auch hier die Anschlußleiter 8 an der Oberseite des Gehäuses 1 aus, und wie dort sind die Mittelabschnitte 8a entlang den Seitenwänden nach unten geführt. Die Anschlußfahnen sind jedoch in diesem Fall als SMT-Kontakte 19 ausgebildet, die an der Oberfläche einer löcherlosen Leiterplatte 20 verlötet werden. Die Lötung erfolgt durch Einbringen einer Wärmestrahlung 13, die durch die Mittelabschnitte 8a der Anschlußleiter schnell nach unten zu den Lötstellen transportiert wird. Auf diese Weise kann die Lötdauer sehr kurz gehalten werden, um die Wärmebelastung des Gehäuses so gering wie möglich zu halten. Falls erforderlich, kann die Gehäuseoberseite mit den Austrittsstellen der Anschlußleiter 8 durch eine reflektierende Folie 14 abgedeckt werden. In jedem Fall werden auch bei dieser SMT-Ausführung eines Relais die Vorteile einer Entkopplung zwischen den Anschlußfahnen und den Austrittsstellen der Anschlußleiter aus dem Gehäuse wirksam.

Da bei dem erfindungsgemäßen Relais die Anschlußleiter jeweils über die Flanken bzw. an der Außenseite der Gehäuse-Seitenwände verlaufen, kann unter Umständen das Problem auftreten, eine ausreichende Isolierung gegenüber einem benachbarten Relais oder einem anderen Bauteil sicherzustellen. Dies kann beispielsweise durch Einfugen zusätzlicher Isolierfolien zwischen den auf der Leiterplatte angeordneten Bauelementen geschehen. Eine vorteilhafte Ausführungsform ist in Figur 6 dargestellt. In diesem Fall wird eine zusätzliche, aus Isoliermaterial bestehende Überkappe 15 verwendet. Diese Überkappe 15 wird nach der Montage über das eigentliche Relaisgehäuse 1 gestülpt. Sie ist so bemessen, daß sie auch die an der Gehäuseaußenseite verlaufenden Anschlußleiter 8 und die Einpreßstifte 9 oder gegebenenfalls auch Flachlötanschlüsse 19 gemäß Figur 5 abdeckt. Eine solche Überkappe kann in einfacher Weise durch Tiefziehen oder auf sonstige Weise hergestellt werden.

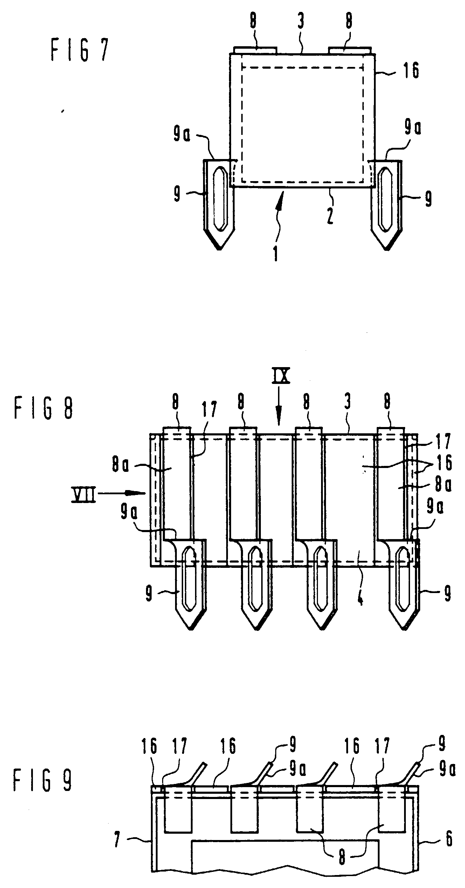

In den Figuren 7 bis 9 ist in den gleichen Ansichten wie in den Figuren 1 bis 3 eine etwas abgewandelte Ausführungsform eines erfindungsgemäßen Relais dargestellt. Hierbei sind die Gehäusewände, zumindest an den Seiten 4 und 5, verstärkt, so daß erhabene Abschnitte 16 entstehen, zwischen denen senkrechte Nuten 17 die Anschlußleiterabschnitte 8b aufnehmen. Auf diese Weise kann das Gehäuse versteift werden, während die Anschlußleiter in den Nuten 17 gegenüber der Außenkontur etwas zurückgesetzt sind.

## Patentansprüche

1. Elektrisches Relais mit einem Gehäuse (1), welches
- eine Bodenseite (2) zum Aufsetzen auf eine Leiterplatte (10; 20),
- aus der von der Bodenseite (2) abgewandten Oberseite (3) des Gehäuses (1) austretende Anschlußelemente (8) und
- mit den Anschlußelementen (8) verbundene Anschlußbahnen (8) aufweist, welche sich mit abgebogenen Abschnitten (8a) entlang von Seitenwänden (4, 5) des Gehäuses (1) bis in den Bereich der Bodenseite (2) erstrecken, wo sie mit Anschlußfahnen (9; 19) zur Kontaktierung auf der Leiterplatte (10; 20) versehen sind,
**dadurch gekennzeichnet daß,** die Anschlußelemente (8) und die zugehörigen Anschlußbahnen (8) durch jeweils einen gemeinsamen, formstabilen Anschlußleiter (8) gebildet sind.

2. Relais nach Anspruch 1, dadurch gekennzeichnet, daß die Anschlußfahnen als Einpreßstiele (9) ausgebildet sind und sich zur Bildung von Einpreßschultern (9a) von der jeweiligen Seitenwand (4, 5) des Gehäuses (1) weg nach außen erstrecken.

3. Relais nach Anspruch 1, **dadurch gekennzeichnet,** daß die Anschlußfahnen (19) zum Zwecke der Oberflächenmontage (SMT) annähernd parallel zur Bodenseite des Gehäuses abgebogen sind.

4. Relais nach einem der Ansprüche 1 bis 3, **dadurch gekennzeichnet,** daß die Seitenwände (4, 5) des Gehäuses (1) von der Oberseite (3) bis zur Bodenseite (2) verlaufende Nuten (17) aufweisen, in denen die abgebogenen Abschnitte (8a) der Anschlußleiter (8) angeordnet sind.

5. Relais nach einem der Ansprüche 1 bis 4, **dadurch gekennzeichnet,** daß die außerhalb des Gehäuses befindlichen Abschnitte der Anschlußleiter (8; 9) zumindest teilweise durch eine zusätzliche Isolierkappe (15) bedeckt sind.

## Claims

1. Electric relay having a housing (1), which has
- a bottom side (2) to be fitted onto a printed circuit board (10; 20),
- connection elements (8), which emerge from the upper side (3), facing away from the bottom side (2), of the housing (1), and
- connection tracks (8), which are connected to the connection elements (8) and which extend with bent sections (8a) along side walls (4, 5) of the housing (1) as far as the region of the bottom side (2), where they are provided with connection lugs (9; 19) for making contact on the printed circuit board (10; 20), characterized in that the connection elements (8) and the associated connection tracks (8) are formed by, in each case, one common, dimensionally stable connection conductor (8).

2. Relay according to Claim 1, characterized in that the connection lugs are designed as press-in parts (9) and extend outwards away from the respective side wall (4, 5) of the housing (1) in order to form press-in shoulders (9a).

3. Relay according to Claim 1, characterized in that the connection lugs (19) are bent approximately parallel to the bottom side of the housing for the purpose of surface mounting (SMT).

4. Relay according to one of Claims 1 to 3, characterized in that the side walls (4, 5) of the housing (1) have grooves (17), which run from the upper side (3) as far as the bottom side (2) and in which the bent sections (8a) of the connection conductors (8) are arranged.

5. Relay according to one of Claims 1 to 4, characterized in that the sections, located outside the housing, of the connection conductors (8; 9) are covered at least partially by means of an additional insulating cap (15).

## Revendications

1. Relais électrique avec un boîtier (1), qui est pourvu
- d'un fond (2) destiné à être posé sur un circuit imprimé (10; 20),
- d'éléments de connexion (8) sortant du côté supérieur (3) du boîtier (1) éloigné du fond (2), et
- de rubans de connexion (8) reliés aux éléments de connexion (8), qui s'étendent le long de parois latérales (4, 5) du boîtier (1) avec des segments pliés (8a), jusque dans la région du fond (2) où ils sont pourvus de pattes de connexion (9; 19) servant à établir le contact avec le circuit imprimé (10; 20),
caractérisé en ce que les éléments de connexion (8) et les rubans de connexion (8) correspondants sont formés, à chaque fois, par un conducteur de connexion (8) indéformable commun.

2. Relais selon la revendication 1, caractérisé en ce que les pattes de connexion sont exécutées en tant que broches d'insertion (9) et s'étendent vers l'extérieur de chacune des parois latérales (4, 5) du boîtier (1) pour former des épaulements d'insertion (9a).

3. Relais selon la revendication 1, caractérisé en ce que les pattes de connexion (19) sont pliées de manière à peu près parallèle par rapport au fond du boîtier en vue du montage en surface (SMT).

4. Relais selon l'une des revendications 1 à 3, caractérisé en ce que les parois latérales (4, 5) du boîtier (1) sont pourvues de rainures (17) qui s'étendent du côté supérieur (3) jusqu'au fond (2) et dans lesquelles les segments pliés (8a) des conducteurs de connexion (8) sont disposés.

5. Relais selon l'une des revendications 1 à 4, caractérisé en ce que les segments des conducteurs de connexion (8; 9) qui sont situés à l'extérieur du boîtier sont couverts, au moins partiellement, par un couvercle isolant (15) supplémentaire.
